# EUROPEAN PATENT APPLICATION

(11) **EP 4 692 678 A1**
(43) Date of publication of application: **11.02.2026**
(21) Application number: 24193666.5
(22) Date of filing: 08.08.2024
(51) Int. Cl.: F25B 9/00, H05K 7/20, F25B 1/00

(54) **COOLING SYSTEM USING WATER AS A REFRIGERANT**

(71) Applicant: Vertiv S.r.l., 35028 Piove di Sacco, (PD) (IT)
(72) Inventor: MASETTO, Filippo, Villanova di Camposampiero (IT); BARBATO, Pierpaolo, Noventa Padovana (IT); HANNAH, George, Whixley (GB)
(74) Representative: Beal, James Michael

(57) **Abstract**

A cooling system is provided. The cooling system includes a compressor, a condenser coupled to the compressor, a valve coupled to the condenser, and a cooling component coupled to the valve and to the compressor. The cooling system also includes at least one conduit configured to transport refrigerant between the compressor, the condenser, the valve and the cooling component in a refrigerant circuit. The refrigerant comprises water at sub-atmospheric pressure.

## Description

This disclosure relates to a cooling system, and in particular to a cooling system using water as a refrigerant.

### Background

In a data centre, servers and other computational equipment can generate a large amount of heat, and typically need to be cooled to prevent overheating. This is important because many industries rely on data centres to operate reliably at all times without interruption. For example, data centres can serve as part of the critical infrastructure of airports, banks and hospitals, for which even short interruptions are unacceptable. As such, it is necessary for a data centre to maintain efficiency, guarantee data integrity and uphold the trust of customers through providing continuous operation. In data centres, as well as other settings, a cooling system can remove excess heat from the servers and the surrounding air in order to provide cooling. This helps regulate the environment in which the servers are housed and therefore helps maintain their continuous, efficient operation.

A computer room air conditioner (CRAC) system is typically configured to cool warm air blown over a coil filled with refrigerant, with a compressor compressing the refrigerant and pumping it through the coil. While different types of refrigerants can be used in such systems, use of some refrigerants is increasingly undesirable due to environmental concerns and associated regulation and costs. Moreover, some natural refrigerants such as CO₂ operate at high pressure and some natural refrigerants such as propane and ammonia are flammable. In addition, ammonia is toxic. These issues can impose additional engineering requirements, increase costs and reduce reliability and safety.

Use of water (also known as R718) is known in some cooling systems. However, the high boiling point of water at atmospheric pressure of 100°C may make it less undesirable for use a two-phase (liquid and gas) cooling system, while single-phase cooling systems provide lower efficiency than two-phase cooling systems. Moreover, use of water to cool computational equipment may cause damage or safety concerns in the case of a leak of the water. These issues have limited the use of water as a refrigerant in various cooling systems.

It would be desirable to provide a cooling system capable of operating with more environmentally friendly refrigerant. It would also be desirable to provide safer, more reliable and more efficient operation of a cooling system.

The present invention seeks to address these and other disadvantages encountered in the prior art.

### Summary

An invention is set out in the independent claims. Optional features are set out in the dependent claims.

According to an aspect, there is provided a cooling system comprising: a compressor; a condenser coupled to the compressor; a valve coupled to the condenser; a cooling component coupled to the valve and to the compressor; and at least one conduit configured to transport refrigerant between the compressor, the condenser, the valve and the cooling component in a refrigerant circuit, wherein the refrigerant comprises water at sub-atmospheric pressure.

### Brief Description of the Drawings

Specific embodiments are now described, by way of example only, with reference to the drawings, in which:
Figure 1 depicts an example cooling system according to the present disclosure;
Figure 2 depicts a further example cooling system according to the present disclosure;
Figure 3 depicts a further example cooling system according to the present disclosure;
Figure 4 depicts a further example cooling system according to the present disclosure.
Figure 5 depicts an example computing device according to the present disclosure.

### Detailed Description

The present disclosure provides a cooling system including a compressor, a condenser coupled to the compressor, a valve coupled to the condenser, and a cooling component coupled to the valve and to the compressor. The cooling system also includes at least one conduit configured to transport refrigerant between the compressor, the condenser, the valve and the cooling component in a refrigerant circuit. The refrigerant comprises water at sub-atmospheric pressure.

The use of water as the refrigerant for the cooling system provides an environmentally friendly, safe and reliable solution. The use of the water at sub-atmospheric pressure enables implementation of a two-phase cooling system at lower temperatures that may be safer and easier to accommodate from an engineering perspective. For example, the boiling point of the water at the sub-atmospheric pressure may be approximately 20°C or 30°C (instead of 100°C as applies at atmospheric pressure). This enables the combined benefits associated with use of water as the refrigerant, avoiding need for high temperature operation, and providing the efficiency gains associated with two-phase systems.

In addition, the use of water at sub-atmospheric pressure means that the risk of damage or safety concerns due to leaks is reduced or avoided. Since the water within the refrigerant circuit is at negative pressure relative to the surrounding environment, this acts to hold the water within the refrigerant circuit and avoid it being released and contacting nearby computational equipment.

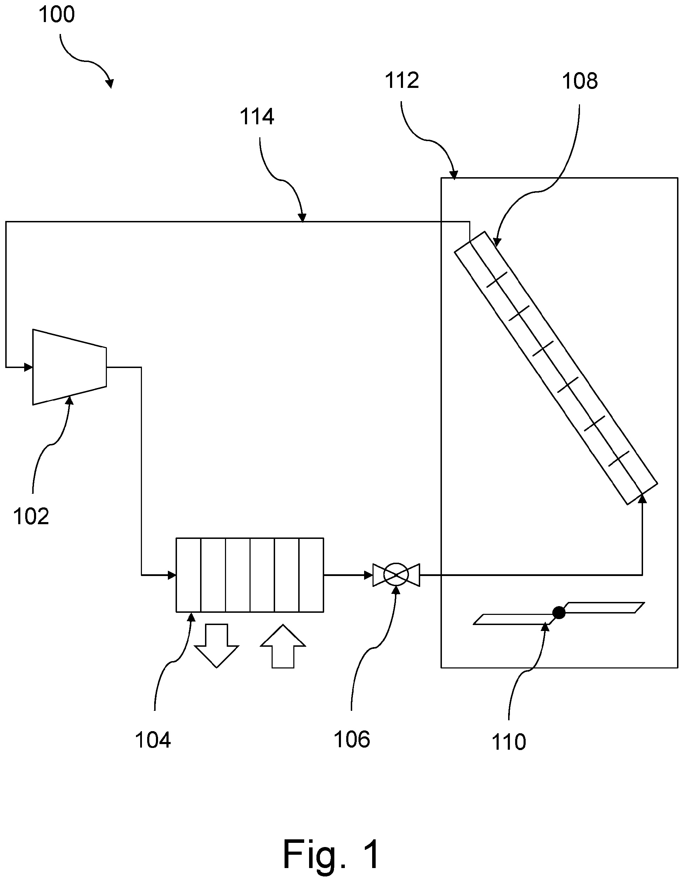

Figure 1 depicts an example cooling system 100 according to the present disclosure. The cooling system 100 is configured to cool a surrounding or adjacent area, for example a server room of a data centre comprising computational equipment supported on racks. While a single circuit cooling system is depicted in Figure 1, the present disclosure is not limited thereto and encompasses multi circuit cooling systems. The cooling system 100 may be described as a computer room air conditioner (CRAC) system.

The cooling system 100 comprises a compressor 102. The compressor is configured to increase the pressure of refrigerant passing therethrough and transfer it to a condenser 104 (described below). The compressor 102 may be a centrifugal compressor, which may be configured to accelerate the refrigerant through one or more impellers in order to convert kinetic energy into potential energy and thereby increase the pressure of the refrigerant. In the compressor, the refrigerant may be in the form of gas. As will be appreciated by the skilled person, any suitable form of compressor may be used, including reciprocal compressors, rotary vane compressors, scroll compressors, screw compressors, etc.

The cooling system 100 comprises a condenser 104 coupled to the compressor 102. The condenser is configured to receive the refrigerant from the compressor 102 and to cool the refrigerant until it condensates (changes state from gas to liquid). The condenser 104 may be a brazed plate condenser, which may also be described as a brazed plate heat exchanger. The brazed plate condenser may comprise channels through which the (relatively warm) refrigerant can flow and channels through which a second (relatively cool) fluid can flow without mixing with the refrigerant. Heat from the refrigerant can thereby be transferred from the refrigerant to the second fluid in order to cool and condense the refrigerant and warm the second fluid. The block arrows in Figure 1 indicate pipes or conduits that may be used to transport this second fluid into and out of the condenser 104. The heat of the second fluid may be recovered and used, e.g. for heating a building. As will be appreciated by the skilled person, any suitable form of condenser may be used, including air-cooled, water-cooled, evaporative and hybrid condensers.

The cooling system 100 comprises a valve 106 coupled to the condenser 104. The valve 106 may also be or may also be described as an expansion valve, an electronic expansion valve (EEV), an injector or an ejector. The valve 106 is configured to receive the refrigerant from the condenser 104 and to feed the refrigerant to a cooling component 108 (described below). The valve 106 may be configured to control the amount of refrigerant that flows to the evaporator 108 and may be configured to control or affect the pressure of the refrigerant in the cooling system 100. The valve 106 may be configured to limit pressure drop in order to provide capacity regulation.

The cooling system 100 comprises a cooling component 108 coupled to the valve 106 and to the compressor 102. The cooling component 108 may be configured to provide cooling to one or more features of the surroundings of the cooling system 100 or the cooling component 108, for example to the surrounding air or to computational equipment of the data centre. The cooling component 108 may be configured to receive refrigerant from the valve 106 and to transfer refrigerant towards the compressor 102.

As depicted in Figure 1, the cooling component 108 may be an evaporator 108. Any suitable form of evaporator 108 may be used, such as evaporators comprising fins, plates, shells, microchannels and/or tubes. The evaporator 108 may be an air-cooled evaporator, which may avoid the need for additional features of water-cooled evaporators such as heat pumps or chilled water coils. In chiller implementations, water is cooled, and then the cooled water can be used to cool the surroundings. This double heat exchange may be less efficient than desired. In contrast, in the arrangement of Figure 1, the evaporator 108 can provide direct heat exchange between the refrigerant and the air, enabling more efficient cooling to be provided.

The evaporator 108 may be configured to cool air passed over the evaporator using the refrigerant. A fan 110 may be directed towards the evaporator 108 and may be configured to direct warm air over the evaporator. As the warm air passes over the evaporator, the cool refrigerant flowing through the evaporator 108 may cool the air through heat exchange, without mixing of the refrigerant and the air. The cooled air may be recirculated around the data centre to absorb further heat. The warming of the refrigerant may cause the refrigerant to evaporate. This evaporated refrigerant may be sucked back towards the compressor 102 for the cycle described above to begin again. The evaporator 108 and the fan 110 may be contained within a housing 112, providing these components within a single integrated unit easily connectable to the rest of the cooling system 100.

While the cooling system 100 is depicted schematically in Figure 1, in practice the distance between the compressor 102 and the cooling component/evaporator 108 may be minimised in view of the internal pressure drop of the refrigerant. The length of the at least one conduit 114 between the compressor 102 and the cooling component/evaporator 108 may be minimised to achieve this, which may also enable a more compact cooling system 100 to be provided. Water is a very low pressure refrigerant, with a very small difference between evaporating and condensing pressures. Small changes in pressure can change the equivalent saturated temperature and can cause a reduction in efficiency. Therefore, the compressor 102 and the cooling component/evaporator 108 may be located adjacent to each other in order to improve the efficiency of the cooling system 100.

The cooling system 100 comprises at least one conduit 114 configured to transport the refrigerant between the compressor 102, the condenser 104, the valve 106 and the evaporator 108 in a refrigerant circuit. The flow of the refrigerant around the refrigerant circuit through the at least one conduit 114 is generally depicted in Figure 1 with straight line arrows. The refrigerant may generally flow in an anticlockwise direction in the depiction of Figure 1. The at least one conduit 114 may be described as comprising a first conduit coupling the compressor 102 to the condenser 104, a second conduit coupling the condenser 104 to the valve 106, a third conduit coupling the valve 106 to the evaporator 108 and a fourth conduit coupling the evaporator 108 to the compressor 102. These conduits may be formed of separate components to collectively form the at least one conduit 114 or may be one substantially continuous conduit.

As used herein, a first component being coupled to a second component may be used to indicate that the first component and the second component are connected such that refrigerant can flow between the first component and the second component. Each of the at least one conduits 114 may comprise a pipe or a tube. The refrigerant may be contained in the at least one conduit 114 to cause it to flow in the desired path between the components of the cooling system 100 and prevent leakage of the refrigerant to the external surroundings.

As described above, the refrigerant is water at sub-atmospheric pressure. As such, the cooling system 100 may be configured to hold the refrigerant at sub-atmospheric pressure at all points around the refrigerant circuit, including at points at which the refrigerant is in a liquid state and at points at which the refrigerant is in a gas state. The cooling system 100 may be configured to hold the refrigerant, for example, at a pressure below 100 kPa, below 50 kPa, below 20 kPa, below 10 kPa, below 5 kPa, below 2 kPa, or below 1 kPa. The cooling system 100, and the at least one conduit 114 thereof, may be configured to transport the water refrigerant between the components of the cooling system 100 at sub-atmospheric pressure. The cooling system 100, and the at least one conduit 114 thereof, may be configured to be able to contain the refrigerant at sub-atmospheric pressure without being deformed, i.e. be made thick/strong/rigid enough to withstand the forces corresponding to the negative pressure of the refrigerant relative to the surroundings.

The use of water at sub-atmospheric pressure as the refrigerant enables the combined benefits associated with use of water as a safe and environmentally friendly refrigerant while avoiding need for high temperature operation and providing the efficiency gains associated with two-phase systems. Moreover, since the water is held at sub-atmospheric pressure, the cooling system 100 is inherently predisposed to prevent leakage of the water refrigerant since the negative pressure relative to the external environment acts to hold the water within the refrigerant circuit and avoid it being released and contacting nearby computational equipment. This increases the safety and reliability of the cooling system 100 and reduces maintenance associated with leaks as well as requirements relating to leak tests.

The cooling system 100 advantageously enables the flexibility and precision cooling of a direct expansion system versus a centralised chilled water application. Moreover, the cooling system may be particularly suitable for small applications, i.e. where the cooling system 100 and the region to be cooled are relatively small. Regulations limit the use of fluorinated gas refrigerants to those with relatively low global warming potential, and there is the potential for widespread refrigerants such as per- and poly fluoroalkyl substances (PFAS) to be banned for altogether for related reasons. The use of water as a refrigerant as described herein can therefore provide a suitable solution as a natural refrigerant.

The cooling system 100 may be configured to detect the presence of any no-condensate/non-condensable gases and purge them in order to provide more reliable operation. For example, a vacuum pump may be coupled to the condenser 104 via a pipeline or conduit. A gas trap or reservoir for storing the non-condensable gases may be provided coupled to the pipeline or conduit or to the vacuum pump. The vacuum pump may be configured to evacuate any non-condensable gages from the condenser 104 via the pipeline or conduit in order to maintain efficient operation of the condenser 104.

The cooling system may be provided within one integrated package, housing or cabinet and installation may require only connecting of water pipes to the condenser 104, which can provide more efficient installation relative to direct expansion systems and avoid need for brazing in the field. The cooling system 100 may be retrofitted to existing chilled water systems in order to provide improved operation with a minimum of disruption or engineering complications.

The cooling system 100 may comprise a controller. The controller may be communicatively coupled to one, multiple or all of the above-described components of the cooling system 100. The controller may be configured to transmit control signals to respective components of the cooling system 100, in order to adjust the operation of the cooling system 100. For example, the controller may be configured to transmit a control signal to the valve 106 to control the flow of refrigerant therethrough/control the pressure of the refrigerant in the refrigerant circuit. Alternatively, or in addition, the controller 100 may be configured to receive data from respective components of the cooling system 100. For example, the cooling system 100 may comprise one or more pressure sensors and/or temperature sensors, which the controller may be configured to receive pressure/temperature data from. The controller may be configured to generate the above-mentioned control signals based on this data.

The controller may be configured to control the valve 106, for example the opening of the valve 106, in order to control the pressure of the cooling system 100, i.e. of the water refrigerant in the refrigerant circuit. This may be used to control the temperature at which evaporation and condensation of the water will occur, which may be adjusted as desired based on current, time-varying cooling need (and/or heat recovery needs).

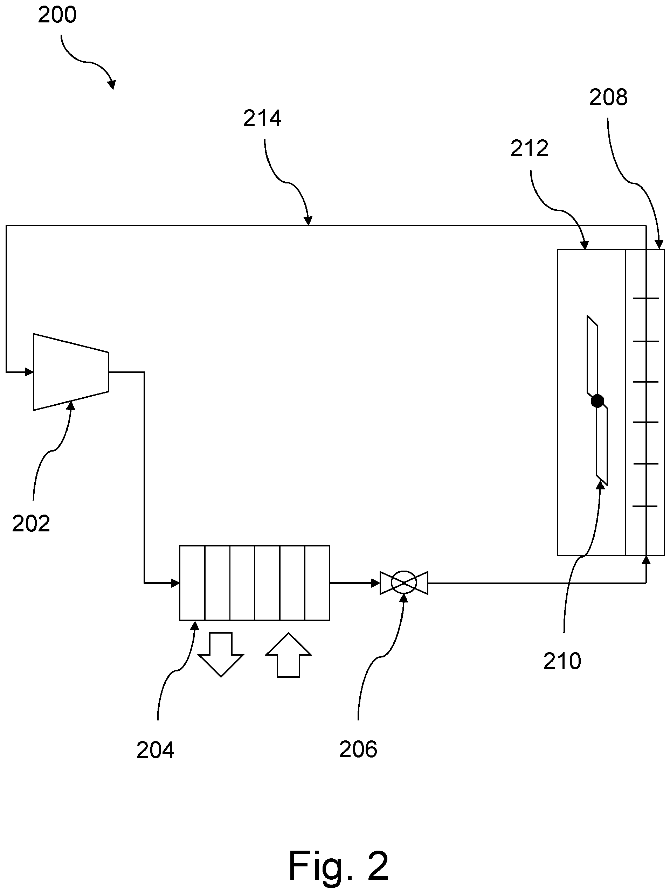

Figure 2 depicts a further example cooling system 200 according to the present disclosure. The cooling system 200 may comprise corresponding features and functions to cooling system 100, except where described otherwise below. The cooling system 200 comprises a compressor 202, a condenser 204, a valve 206 and at least one conduit 214, which may generally correspond to the corresponding components of Figure 1.

The cooling system 200 comprises a thermal wall 212 comprising an evaporator 208 and a fan 210. The evaporator 208 and the fan 210 may generally correspond to the corresponding components of Figure 1. The thermal wall 212 provides a different flow configuration relative to Figure 1, which may be more suitable for particular layouts of data centres. For example, the thermal wall 212 may be particularly suitable for slab floor data centres as opposed to raised floor data centres. The thermal wall 212 houses the evaporator 208 and the fan 210 in one integrated unit and may provide a particularly space-efficient solution.

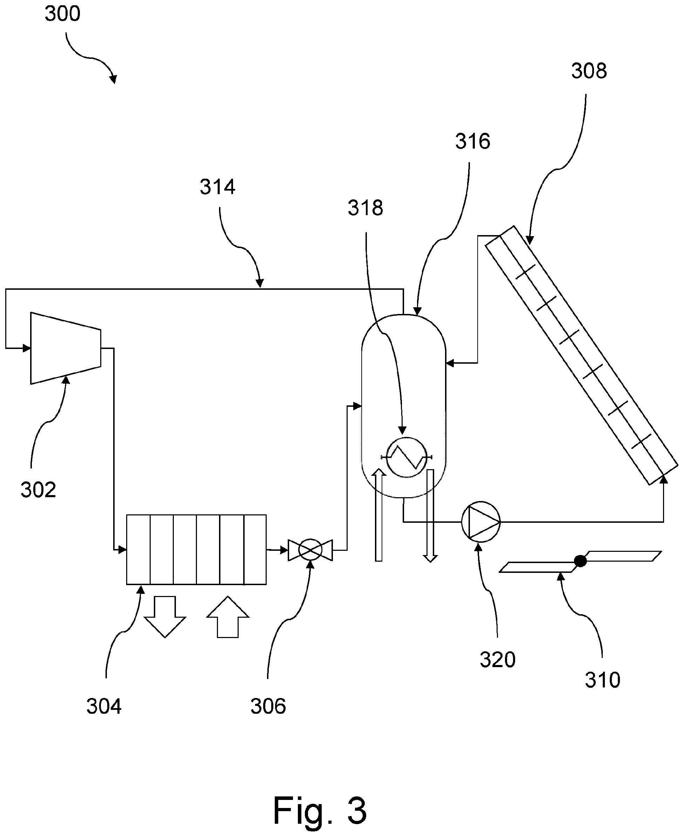

Figure 3 depicts a further example cooling system 300 according to the present disclosure. The cooling system 300 may comprise corresponding features and functions to cooling systems 100 and 200, except where described otherwise below. The cooling system 300 comprises a compressor 302, a condenser 304, a valve 306, an evaporator 308, a fan 310 and at least one conduit 314, which may generally correspond to the corresponding components of Figures 1 and 2. While no housing 112 (see Figure 1) is depicted in Figure 3 for ease of illustration, a housing 112 may also be implemented in the arrangement of Figure 3. The arrangement of Figure 3 can also be implemented with a thermal wall 212 as depicted in Figure 2.

The cooling system 300 comprises a liquid separator 316. The liquid separator 316 may be configured to separate the refrigerant in liquid phase from the refrigerant in gas phase. The liquid refrigerant may be located predominantly at the bottom of the liquid separator 316 (e.g. by action of gravity), while the gas refrigerant may be located predominantly at the top of the liquid separator 316.

The liquid separator 316 may comprise a first inlet coupled to the valve 306 and configured to receive liquid refrigerant therefrom. The liquid separator 316 may comprise a first outlet coupled to the cooling component/evaporator 308 via a pump 320 configured to feed the liquid refrigerant to the cooling component/evaporator 308. The liquid separator 316 may comprise a second inlet coupled to the cooling component/evaporator 308 and configured to receive gas refrigerant therefrom. The liquid separator 316 may comprise a second outlet coupled to the compressor 302 and configured to transfer gas refrigerant thereto. The pump 320 may operate on behalf of a valve (modulated by an inverter).

The liquid separator 316 comprises a heat exchanger 318 disposed inside the liquid separator 316. The heat exchanger 318 may be located close to the bottom of the liquid separator 316 to contact the liquid refrigerant therein. The heat exchanger 318 may be configured to transfer heat between different temperature fluids. This heat transfer/heat exchange may be made via a series of surfaces such as finned tube pipes. The block arrows in Figure 3 indicate pipes or conduits that may be used to transport cool and warm fluid towards and away from the heat exchanger.

The liquid separator 316 may be described as a flash tank or a receiver. This implementation of the liquid separator 316 enables use of an external cold source as an alternative to the refrigerant from the compressor 302 and the condenser 304. When the ambient temperature is low, e.g. during the winter season, cold water can be conveyed to the liquid separator 316 from a dry cooler via the above-described pipes or conduits. The cold water may cool the refrigerant (water) in the liquid separator 316, which can then be used to cool the air at the evaporator 308. The dry cooler may be a heat exchange cooling system configured to cool the water therein using cold ambient air flow. As a further alternative, cold water from district heating may be used as the cold source. In any case, the heat exchanger 318 inside the liquid separator 318 may be used to transfer heat from the refrigerant (water) in the cooling system 300 to the received cold water, thereby reducing the temperature of the refrigerant (water) such that it can cool the air at the evaporator 308.

The implementation of the heat exchanger 318 inside the liquid separator 316 enables heat recovery at relatively low temperatures (like in a computer room air handler, CRAH, application). This can provide a low/moderate temperature heat source that utilises waste heat, providing heat recovery at both high and low temperature without impacting thermal regulation and precision cooling. If heating a location that is distant from the cooling system 300, it is desirable for the fluid transferring the heat to have a temperature close to the ground temperature, rather than a very hot temperature, to reduce heat losses. Normally CRACs can provide cooling at higher temperatures (recovered from a condenser) or require an additional coil (e.g. using glycol, in a free cooling application) for granting this function. However, the arrangement of Figure 3 achieves low temperature heat recovery with a higher efficiency.

Providing the liquid separator 316 at the inlet of the compressor 302, as depicted in Figure 3, means free cooling can be provided. An internal pipe connected to the dry cooler, as described above, can be provided to provide cooling. A small pump or valve depending on the system pressure can be used for providing the correct flow on the coils, enabling use of just one internal coil and thereby minimising the components required and the system cost. If the heat recovery is done at low/moderate temperatures, this may also grant the ability to use the cooling system 300 for rejecting the cooling from a central heat pump facility.

The arrangement of Figure 3 therefore provides a more efficient solution with more versatile applicability to different water setpoints. It enables heat recovery both at high and low temperatures without impacting on thermal regulation and precision cooling. It also enables use of ambient cooling as an alternative cold source.

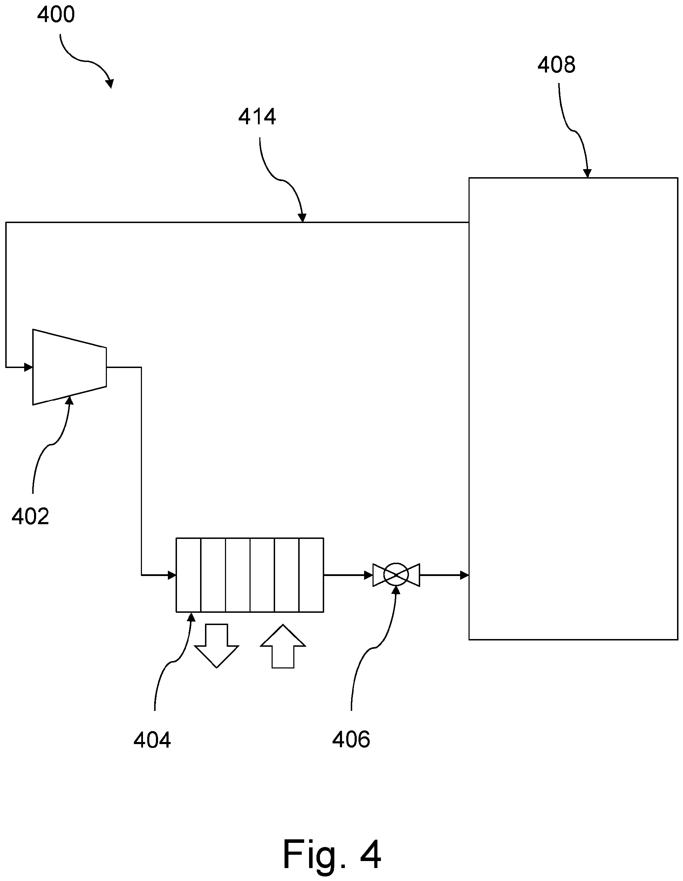

Figure 4 depicts a further example cooling system 400 according to the present disclosure. The cooling system 400 may comprise corresponding features and functions to cooling systems 100, 200 and 300, except where described otherwise below. The cooling system 400 comprises a compressor 402, a condenser 404, a valve 406, and at least one conduit 414, which may generally correspond to the corresponding components of Figures 1, 2 and 3.

The cooling system 400 comprises a cooling component 408, in place of the use of the evaporator as the cooling component as focused on in most detail in relation to Figures 1-3. The cooling component 408 comprises a structural component of the racks used to support computational equipment of the data centre. For example, the cooling component 408 may comprise a panel, a door (e.g. a rear door), a cold plate or other heat sink. In other words, in the cooling system 400, the at least one conduit 414 is arranged such that the refrigerant flowing therein can directly cool the components of the rack. This may provide a particularly efficient solution providing and distributing cooling directly to where it is required in close proximity to the relevant heat sources to provide high heat density, high efficiency, and avoid the need for additional components or heat exchanges.

The cooling system 400 may be configured to provide liquid cooling via rear door cooling, direct to chip cooling and/or immersion cooling. A coolant distribution unit, which may be part of or coupled to the at least one conduit 414, may be configured to provide the refrigerant to one or more features of the rack or supported within the rack.

In rear door cooling implementations, the cooling system 400, and the at least one conduit 414 thereof, may be arranged to supply the refrigerant to the rear door of the rack such that it flows across a surface of the rear door or flows through channels within the rear door. The rear door may be considered as an implementation of the cooling component 408 described herein. In some examples, the rear door may be implemented as or described as a heat exchanger. Heat from the computational equipment supported by the rack may be transferred to the refrigerant flowing across or through the rear door/heat exchanger. The cooling system 400, and the at least one conduit 414 thereof, may be arranged to then transport the warmed refrigerant away from the rear door/heat exchanger.

In direct to chip implementations, the cooling system 400, and the at least one conduit 414 thereof, may be arranged to supply the refrigerant to a cold plate. The cold plate may be considered as an implementation of the cooling component 408 described herein. The cold plate may be disposed in contact with or adjacent to computational equipment supported by the rack. The cold plate may be metallic. The refrigerant may flow in channels through the cold plate and absorb heat from the computational equipment. The cooling system 400, and the at least one conduit 414 thereof, may be arranged to then transport the warmed refrigerant away from the cold plate.

In immersion cooling implementations, the cooling system 400, and the at least one conduit 414 thereof, may be arranged to supply the refrigerant to the computational equipment of the rack such that it is immersed or submerged in the refrigerant, e.g. within a tank or container. The computational equipment itself may be considered as the cooling component 408. Heat from the computational equipment may be transferred to the refrigerant through direct contact with the refrigerant. The cooling system 400, and the at least one conduit 414 thereof, may be arranged to then transport the warmed refrigerant away from the computational equipment.

In some examples, the refrigerant circuit may be arranged to cool a single rack and other cooling systems may be provided and arranged to cool other racks. In other examples, the refrigerant circuit may be arranged to cool multiple racks. A single valve 406 (e.g. an ejector or mass distributor), or a series of these may be provided for feeding the cooling components 408 of multiple racks. The valve(s) 406 may be configured to feed the cooling component(s) 408 with a time-varying amount of refrigerant based on current need. The valve(s) 406 may be controlled to perform this function by the controller described herein.

In liquid cooling applications, the use of direct expansion systems can be quite complicated due to constraints on the refrigerants that are acceptable to use for environmental and safety reasons. In addition, single-phase applications are less efficient than would be desirable. The cooling system 400 uses water as a refrigerant in a two-phase application, addressing both of these issues. In addition, the cooling system 400 may be easier to deploy in practice since it can reuse hydraulic circuits used in current chilled water systems. Since it is a water-cooled direct expansion system, the transition is smoother/less complex than if moving to air-cooled systems.

Use of chilled water in close proximity to computational equipment can lead to concerns about damage or safety if a leak occurs. However, since the cooling system 400 is arranged to use water at sub-atmospheric pressure as the refrigerant, this acts to hold the water within the cooling system 400 and prevent it from being released therefrom. Therefore, this improves the safety and reliability of the cooling system 400, while also reducing engineering complexity and cost through operating at lower pressures than traditional systems.

The cooling unit(s), cooling system and/or controller(s) described herein may be configured to perform any of the method or process steps presently disclosed and may comprise computer executable instructions which, when executed by a processor cause the processor to perform any of the method or process steps presently disclosed, or when executed by the controller(s) cause the controller(s) to perform any of the method or process steps presently disclosed, or when executed by the cooling unit(s)/cooling system, cause the cooling unit(s)/cooling system to perform any of the method or process steps presently disclosed. Any of the steps or functions that the cooling unit(s), cooling system and/or controller(s) are configured to perform may be considered as method steps of the present disclosure and may be embodied in computer executable instructions for execution by a processor. A computer-readable medium may comprise the above-described computer executable instructions.

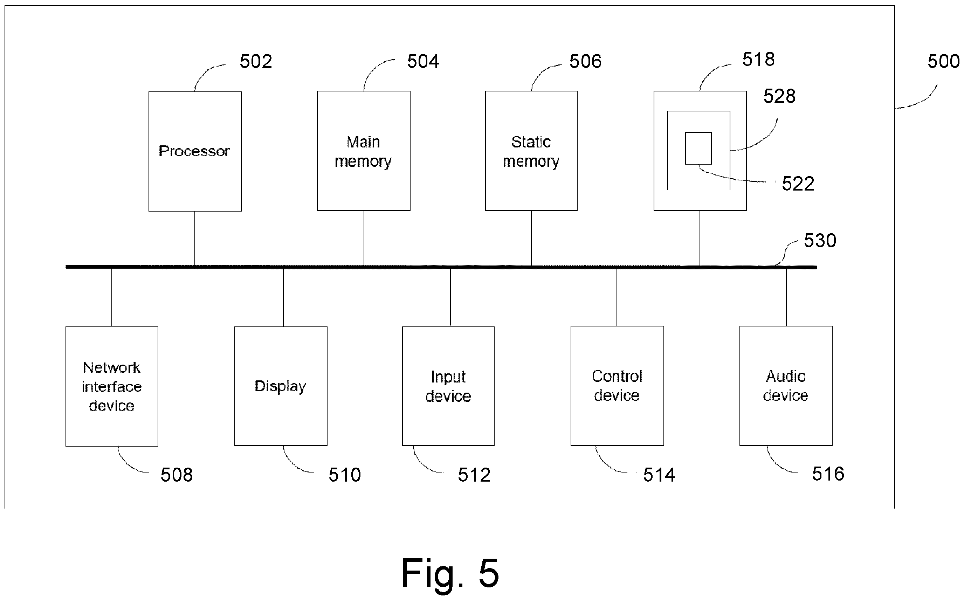

Figure 5 illustrates a block diagram of one implementation of a computing device 500 within which a set of instructions, for causing the computing device to perform any one or more of the methodologies discussed herein, may be executed. In alternative implementations, the computing device may be connected (e.g., networked) to other machines in a Local Area Network (LAN), an intranet, an extranet, or the Internet. The computing device may operate in the capacity of a server or a client machine in a client-server network environment, or as a peer machine in a peer-to-peer (or distributed) network environment. The computing device may be a personal computer (PC), a tablet computer, a set-top box (STB), a Personal Digital Assistant (PDA), a cellular telephone, a web appliance, a server, a network router, switch or bridge, or any machine capable of executing a set of instructions (sequential or otherwise) that specify actions to be taken by that machine. Further, while only a single computing device is illustrated, the term "computing device" shall also be taken to include any collection of machines (e.g., computers) that individually or jointly execute a set (or multiple sets) of instructions to perform any one or more of the methodologies discussed herein. The computing device 500 may correspond to the one or more of the controllers described herein.

The example computing device 500 includes a processing device 502, a main memory 504 (e.g., read-only memory (ROM), flash memory, dynamic random access memory (DRAM) such as synchronous DRAM (SDRAM) or Rambus DRAM (RDRAM), etc.), a static memory 506 (e.g., flash memory, static random access memory (SRAM), etc.), and a secondary memory (e.g., a data storage device 518), which communicate with each other via a bus 530.

Processing device 502 represents one or more general-purpose processors such as a microprocessor, central processing unit, or the like. More particularly, the processing device 502 may be a complex instruction set computing (CISC) microprocessor, reduced instruction set computing (RISC) microprocessor, very long instruction word (VLIW) microprocessor, processor implementing other instruction sets, or processors implementing a combination of instruction sets. Processing device 502 may also be one or more special-purpose processing devices such as an application specific integrated circuit (ASIC), a field programmable gate array (FPGA), a digital signal processor (DSP), network processor, or the like. Processing device 502 is configured to execute the processing logic (instructions 522) for performing the operations and steps discussed herein.

The computing device 500 may further include a network interface device 508. The computing device 500 also may include a video display unit 510 (e.g., a liquid crystal display (LCD) or a cathode ray tube (CRT)), an alphanumeric input device 512 (e.g., a keyboard or touchscreen), a cursor control device 514 (e.g., a mouse or touchscreen), and an audio device 516 (e.g., a speaker).

The data storage device 518 may include one or more machine-readable storage media (or more specifically one or more non-transitory computer-readable storage media) 528 on which is stored one or more sets of instructions 522 embodying any one or more of the methodologies or functions described herein. The instructions 522 may also reside, completely or at least partially, within the main memory 504 and/or within the processing device 502 during execution thereof by the computer system 500, the main memory 504 and the processing device 502 also constituting computer-readable storage media.

The various methods and processes described above may be implemented by a computer program. The computer program may include computer code arranged to instruct a computer to perform the functions of one or more of the various methods described above. The computer program and/or the code for performing such methods may be provided to an apparatus, such as a computer, on one or more computer readable media or, more generally, a computer program product. The computer readable media may be transitory or non-transitory. The one or more computer readable media could be, for example, an electronic, magnetic, optical, electromagnetic, infrared, or semiconductor system, or a propagation medium for data transmission, for example for downloading the code over the Internet. Alternatively, the one or more computer readable media could take the form of one or more physical computer readable media such as semiconductor or solid state memory, magnetic tape, a removable computer diskette, a random access memory (RAM), a read-only memory (ROM), a rigid magnetic disc, and an optical disk, such as a CD-ROM, CD-R/W or DVD.

In an implementation, the modules, components and other features described herein can be implemented as discrete components or integrated in the functionality of hardware components such as ASICS, FPGAs, DSPs or similar devices.

A "hardware component" is a tangible (e.g., non-transitory) physical component (e.g., a set of one or more processors) capable of performing certain operations and may be configured or arranged in a certain physical manner. A hardware component may include dedicated circuitry or logic that is permanently configured to perform certain operations. A hardware component may be or include a special-purpose processor, such as a field programmable gate array (FPGA) or an ASIC. A hardware component may also include programmable logic or circuitry that is temporarily configured by software to perform certain operations.

Accordingly, the phrase "hardware component" should be understood to encompass a tangible entity that may be physically constructed, permanently configured (e.g., hardwired), or temporarily configured (e.g., programmed) to operate in a certain manner or to perform certain operations described herein.

In addition, the modules and components can be implemented as firmware or functional circuitry within hardware devices. Further, the modules and components can be implemented in any combination of hardware devices and software components, or only in software (e.g., code stored or otherwise embodied in a machine-readable medium or in a transmission medium).

Unless specifically stated otherwise, as apparent from the following discussion, it is appreciated that throughout the description, discussions utilizing terms such as " receiving", "determining", "comparing ", "enabling", "maintaining," "identifying," "adjusting, " "transmitting," "generating," "operating," or the like, may refer to the actions and processes of a computer system, or similar electronic computing device, that manipulates and transforms data represented as physical (electronic) quantities within the computer system's registers and memories into other data similarly represented as physical quantities within the computer system memories or registers or other such information storage, transmission or display devices.

The approaches described herein may be embodied on a computer-readable medium, which may be a non-transitory computer-readable medium. The computer-readable medium may carry computer-readable instructions arranged for execution upon a processor so as to cause the processor to carry out any or all of the methods described herein.

The term "computer-readable medium" as used herein refers to any medium that stores data and/or instructions for causing a processor to operate in a specific manner. Such storage medium may comprise non-volatile media and/or volatile media. Non-volatile media may include, for example, optical or magnetic disks. Volatile media may include dynamic memory. Exemplary forms of storage medium include, a floppy disk, a flexible disk, a hard disk, a solid state drive, a magnetic tape, or any other magnetic data storage medium, a CD-ROM, any other optical data storage medium, any physical medium with one or more patterns of holes, a RAM, a PROM, an EPROM, a FLASH-EPROM, NVRAM, and any other memory chip or cartridge.

It is to be understood that the above description is intended to be illustrative, and not restrictive. Many other implementations will be apparent to those of skill in the art upon reading and understanding the above description. Although the present disclosure has been described with reference to specific example implementations, it will be recognized that the disclosure is not limited to the implementations described, but can be practiced with modification and alteration within the scope of the appended claims. Accordingly, the specification and drawings are to be regarded in an illustrative sense rather than a restrictive sense. The scope of the disclosure should, therefore, be determined with reference to the appended claims, along with the full scope of equivalents to which such claims are entitled.

## Claims

1. A cooling system comprising:
a compressor;
a condenser coupled to the compressor;
a valve coupled to the condenser;
a cooling component coupled to the valve and to the compressor; and
at least one conduit configured to transport refrigerant between the compressor, the condenser, the valve and the cooling component in a refrigerant circuit, wherein the refrigerant comprises water at sub-atmospheric pressure.

2. The cooling system according to claim 1, wherein the cooling component comprises an evaporator configured to cool air passed over the evaporator using the refrigerant.

3. The cooling system according to claim 2, wherein the evaporator is an air-cooled evaporator.

4. The cooling system according to claim 2 or claim 3, comprising a fan configured to direct the air over the evaporator.

5. The cooling system according to claim 1, wherein the cooling component comprises a structural feature of a rack for supporting computational equipment, the structural feature and the refrigerant circuit being arranged for the refrigerant to cool the structural feature.

6. The cooling system according to claim 5, wherein the structural component comprises one or more of a door, a panel or a cold plate of the rack.

7. The cooling system according to any preceding claim, further comprising a liquid separator with an internal heat exchanger comprised therein, the liquid separator being coupled to the at least one conduit.

8. The cooling system according to claim 7, wherein the liquid separator comprises a first inlet coupled to the valve, a first outlet coupled to the cooling component via a pump of the cooling system, a second inlet coupled to the cooling component, and a second outlet coupled to the compressor.

9. The cooling system according to any preceding claim, wherein the cooling component comprises a thermal wall, the thermal wall comprising an integrated fan and evaporator.

10. The cooling system according to any preceding claim, wherein the refrigerant circuit comprises water in liquid phase in a first part of the refrigerant circuit and water in gas phase in a second part of the refrigerant circuit.

11. The cooling system according to any preceding claim, wherein the condenser is a brazed plate condenser.

12. The cooling system according to any preceding claim, wherein the valve comprises an electronic expansion valve, an injector or an ejector.

13. The cooling system according to any preceding claim, wherein the compressor is a centrifugal compressor.

14. The cooling system according to any preceding claim, wherein the cooling unit is a computer room air conditioner, CRAC, unit.

15. The cooling system according to any preceding claim, further comprising a controller configured to transmit a control signal to the valve to control the flow of the refrigerant therethrough and/or to control pressure of the refrigerant in the refrigerant circuit.
